# EUROPÄISCHE PATENTSCHRIFT

(11) **EP 0 954 099 B1**
(45) Veröffentlichungstag und Bekanntmachung des Hinweises auf die Patenterteilung: **14.06.2006**
(21) Anmeldenummer: 99100218.9
(22) Anmeldetag: 08.01.1999
(51) Int. Cl.: H03K 17/97, H03K 17/95

(54) **Druckschalter**
Pressure switch
Interrupteur à pression

(30) Priorität: 28.04.1998 DE 19818841
(43) Veröffentlichungstag der Anmeldung: 03.11.1999
(73) Patentinhaber: ROBERT BOSCH GMBH, 70442 Stuttgart (DE)
(72) Erfinder: Schuttenberg, Eckard, 70378 Stuttgart (DE)
(74) Vertreter: Thürer, Andreas

(56) Entgegenhaltungen:
- EP-A- 0 620 647
- DE-A- 3 505 772
- DE-A- 4 141 162
- JP-A- 9 007 477
- JP-A- 9 092 104
- US-A- 5 034 621

## Beschreibung

Die Erfindung geht aus von einem Druckschalter entsprechend der Gattung des Anspruchs 1. Druckschalter werden beispielsweise zur Steuerung von druckmittelbetätigten Anlagen eingesetzt und weisen ein Gehäuse mit einem Zylinder auf, in dem ein druckbeaufschlagbarer Kolben verschiebbar geführt ist. Die Kolbenbewegung wird von einem Schaltelement in ein elektrisches Signal umgesetzt. Hierfür ist es bekannt mechanische oder berührungslos arbeitende elektronische Schaltelemente zu verwenden.

JP-A-09 007477 beschreibt einen Membrandruckschalter mit einem zweiteiligen Gehäuse und einer zwischen den Gehäuseteilen befestigten Membran. Im unteren Gehäuseteil ist eine Druckkammer gebildet, die durch die Membran gegenüber dem oberen Gehäuseteil begrenzt ist. Im oberen Gehäuseteil sitzt ein federbeaufschlagter Kolbeneinsatz auf der Membran. In dem Kolbeneinsatz ist ein Permanentmagnet angeordnet. An der dem Permanentmagneten gegenüberliegenden Gehäuseinnenseite ist ein Hall-Sensor befestigt. Über Kabel ist der Hall-Sensor mit einer außerhalb des Gehäuses vorgesehenen Auswerteelektronik verbunden, die ein Schaltsignal erzeugt.

Aus JP-A-09 092104 ist ein Membrandruckschalter mit einem Reedschalter bekannt. Zwischen Gehäuseunterseite und Gehäuseoberseite ist eine Membran eingesetzt, die einen in der Gehäuseunterseite gebildeten Druckraum begrenzt. An der Membran ist eine Zylinderhülse befestigt, auf die ein Ringmagnet aufgesteckt ist. Der Reedschalter ragt in die Zylinderhülse hinein. Kommt der Ringmagnet mit dem Kontaktbereich des Reedschalters zur Deckung wird ein Schaltvorgang ausgelöst.

Während mechanisch arbeitende Schaltelemente Probleme bzgl. Kontaktprellen, Kontaktverschleiß oder Übergangswiderständen verursachen können, haben berührungslose elektronische Schaltelemente den Nachteil, dass sie aus einer Vielzahl von getrennt voneinander angeordneten Einzelbauteilen, wie Sensor, Auswerteelektronik etc. bestehen, die durch Kabel miteinander verbunden werden müssen. Zur Kontaktierung werden zumeist teuer herzustellende und störanfällige Lötungen eingesetzt. Dabei kann es durch Verwechselungen der Kabel zu Fehlkontaktierungen kommen. Zudem ist für derartige Kabelverbindungen im Druckschalter relativ viel Bauraum erforderlich. Vielfach ist auch eine kostenverursachende lagegerechte und positionsgenaue Anordnung der Einzelteile notwendig, um eine zuverlässige Schalterfunktion sicherzustellen. Des weiteren müssen die hydraulischen Komponenten des Druckschalters für eine Wechselwirkung mit einem berührungslosen Sensor konstruktiv auf diesen abgestimmt werden. Dies ist aufwendig und ebenfalls bauraumintensiv.

Es ist die Aufgabe der vorliegenden Erfindung einen verbesserten Druckschalter anzugeben.

Diese Aufgabe wird durch einen Druckschalter mit den Merkmalen des Patentanspruchs' 1 gelöst.

Ein Druckschalter mit den kennzeichnenden Merkmalen des Anspruchs 1 weist den Vorteil auf, dass sein Schaltelement ein vormontierbares, d.h. von den hydraulischen Komponenten losgelöstes, mechanisch betätigbares Einzelbauelement ist, das berührungslos schaltet und das ohne Lötverbindungen in einen von aussen an einen Druckschalter anbaubaren Gerätestecker integrierbar ist. Dieser Gerätestecker ist dadurch im Reparaturfall leicht auszutauschen und erfordert annährend keinen Einstell- bzw. Justieraufwand. Erreicht wird dies durch den Einsatz eines magnetfeldempfindlichen Sensors in einem Schaltelement, das über Steckkontakte mit zugeordneten Kontaktaufnahmen im Innern des Gerätesteckers zuverlässig elektrisch gekoppelt ist. Weitere Vorteile oder vorteilhafte Ausgestaltungen der Erfindung ergeben sich aus den Unteransprüchen und der Beschreibung.

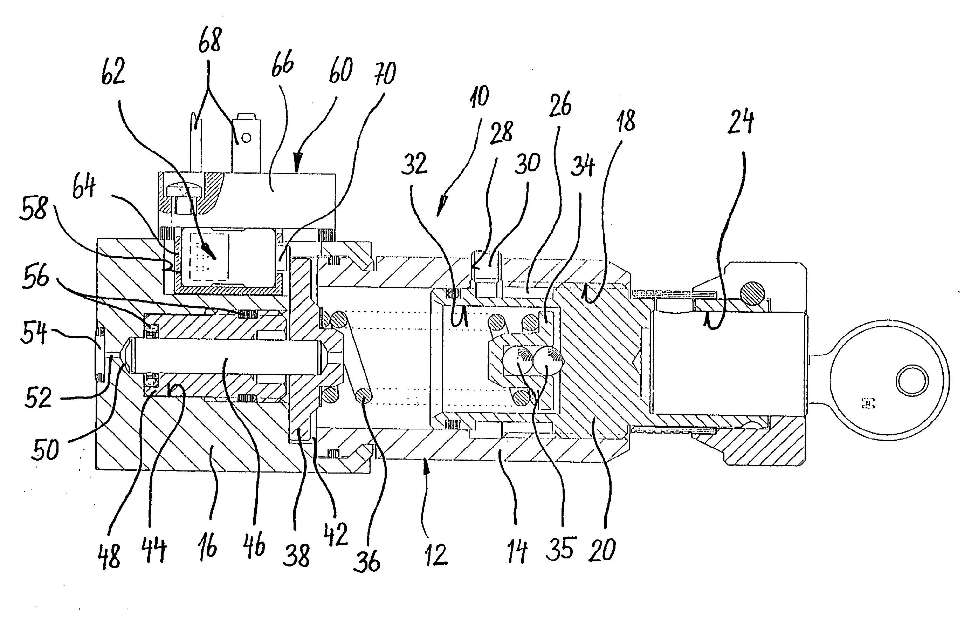

Ein Ausführungsbeispiel der Erfindung ist in der Zeichnung dargestellt und in der nachfolgenden Beschreibung näher erläutert. Die einzige Figur zeigt einen Druckschalter im Längsschnitt.

### Beschreibung des Ausführungsbeispiels

Der dargestellte Druckschalter 10 hat ein Gehäuse 12, das exemplarisch aus einem Grundkörper 14 besteht, der in einen quaderförmigen Steuerblock 16 druckdicht eingesetzt und anschließend verstemmt ist. Den Grundkörper 14 bildet ein zylindrisches Hohlprofil, das an seinem vom Steuerblock 16 abgewandten Ende ein Innengewinde 18 aufweist. In dieses Innengewinde 18 ist eine Verstellspindel 20 eingeschraubt. Die Verstellspindel 20 ist an ihrer nach außen weisenden Stirnfläche aus Montage- und Einstellgründen mit einer Vorrichtung 24 versehen, die zur Vermeidung von unbeabsichtigten Betätigungen abschließbar ist. Am Umfang der Verstellspindel 20 ist eine Aussparung 26 vorgesehen, in die im montierten Zustand eine in einer radialen Gewindebohrung 28 des Grundkörpers 14 angeordnete Madenschraube 30 eingreift, um die Verstellspindel 20 ortsfest am Grundkörper 14 zu fixieren.

Im Bereich ihres im Inneren des Grundkörpers 14 liegenden Endes weist die Verstellspindel 20 eine zentrisch angeordnete, sacklochförmige Ausnehmung 32 auf. In dieser Ausnehmung 32 befindet sich ein Federteller 34 zur Führung einer Druckfeder 36. Dieser Federteller 34 ist hutförmig ausgebildet und weist in seiner nach außen offenen zentrischen Ausnehmung zwei seitlich von der Wandung des Federtellers geführte, axial hintereinander liegende Kugeln 35 auf. Eine der beiden Kugeln 35 ragt über den Rand des Federtellers 34 hinaus und stützt sich am Boden der Ausnehmung 32 ab. Dadurch wird in Wirkverbindung mit der Druckfeder 36 eine Schiefstellung des Federtellers 34 weitestgehend vermieden.

Das dem Federteller 34 abgewandte Ende der Druckfeder 36 liegt an einem Schaltteller 38 an. Dieser Schaltteller 38 ist axial beweglich in einer Kammer 42 angeordnet, die sich zwischen dem Grundkörper 14 und dem angeschraubten Steuerblock 16 ergibt. Der Steuerblock 16 ist dazu mit einer mehrfach abgesetzten Durchgangsbohrung 44 versehen.

Auf seiner dem Steuerblock 16 zugewandten Seite ist in den Schaltteller 38 ein zentrisch angeordneter Kolben 46 eingepreßt. Letzterer ist in einem hülsenförmigen Ventileinsatz 48, der in der Durchgangsbohrung 44 des Steuerblocks 16 festgelegt ist, axial beweglich geführt. Der Kolben 46 ist ein massives, rotationssymmetrisches Bauelement mit zwei identisch ausgebildeten Enden und kann somit lageunabhängig am Schaltteller 38 befestigt werden. Beide Enden des Kolbens 46 sind zur Vereinfachung des Fügevorgangs mit dem Schaltteller 38 mit Einführfasen versehen. Mit seinem freien Ende ragt der Kolben 46 über den Ventileinsatz 48 hinaus und endet in einer Druckkammer 50.

Diese Druckkammer 50 ist über einen Zulauf 52 und einen nach außen abgedichteten Anschluß 54 mit Druckmedium beaufschlagbar. Um eine Druckmittelleckage aus der Druckkammer 50 zu verhindern, ist der Ventileinsatz 48 sowohl an seinem Außen- als auch an seinem Innenumfang mit Dichtkörpern 56 versehen.

An einer Außenseite des Steuerblocks 16 ist eine mit der Kammer 42 in Verbindung stehende Aufnahmeöffnung 58 ausgebildet. In diese Aufnahmeöffnung 58 ist ein Gerätestecker 60 eingesetzt. Der Gerätestecker 60 gliedert sich in einen in die Aufnahmeöffnung 58 hineinragenden Bund 64 und einen einstückig mit dem Bund 64 verbundenen, außenliegenden Befestigungssockel 66. Aufgrund der Formgebung, beispielsweise durch umfangseitig ausgebildete Abflachungen an der Aufnahmeöffnung 58 bzw. der Außenkontur des Bundes 64 sind beide Bauteile lagegerecht und verdrehsicher zueinander angeordnet. Der Befestigungssockel 66 überragt den Bund 64 allseitig und weist nach außen zeigende Kontakte 68 zur elektrischen Kontaktierung eines Schaltelements 62 auf, das in einem vom Bund 64 des Gerätesteckers 60 umschlossenen Innenraum angeordnet ist. Das Schaltelement 62 besteht im wesentlichen aus einem aus dem Stand der Technik bekannten, magnetfeldempfindlichen Sensor, beispielsweise einem als Hall-Schalter ausgebildeten Sensor und einer zugeordneten Auswerteelektronik, wobei beide Komponenten durch nicht gezeichnete Steckkontakte leitend mit den inneren Enden der Kontake 68 des Gerätesteckers 60 verbunden sind. Das Gehäuse des Gerätesteckers 60 ist aus Kunststoff, vorzugsweise in einem Spritzgießprozeß hergestellt - seine metallischen Kontakte 68 sind als Einlegeteile zumindest teilweise in dieses Gehäuse einspritzbar.

Eine Wechselwirkung zwischen dem druckmittelbeaufschlagten Kolben 46 und dem Schaltelement 62 erfolgt auf mechanischem Wege mittels eines im Bereich des Bundes 64 des Gerätesteckers 60 radial über diesen herausragenden Betätigungsstößels 70. Dieser Betätigungsstößel 70 liegt an dem mit dem Kolben 46 verbundenen Schaltteller 38 an und wirkt mit dem Sensor im Innern des Schaltelements 62 derart zusammen, daß eine Bewegung des Schalttellers 38 eine Veränderung des Magnetfeldes im Sensor auslöst. Diese Magnetfeldveränderung wird von der ebenfalls im Inneren des Schaltelements 62 angeordneten Auswerteelektronik erfaßt und bei entsprechender Größe in eine Veränderung der Spannungsverhältnisse an den Kontakten 68 des Gerätesteckers 60 umgesetzt. Dieser Umschaltvorgang geschieht berührungslos, so daß im Vergleich zu mechanisch arbeitenden Schaltelementen kein Verschleiß oder keine Übergangswiderstände auftreten können.

Zur Funktionsbeschreibung des erfindungsgemäßen Druckschalters 10 wird davon ausgegangen, daß die Druckkammer 50 mit Druckmittel versorgt ist. Aufgrund des Drucks im Druckmittel erfährt der Kolben 46 eine erste Axialkraft in Richtung des Grundkörpers 14. Dieser ersten Axialkraft wirkt eine von der Vorspannung der Druckfeder 36 abgängige zweite Axialkraft entgegen. Übersteigt der Druck im Druckmittel einen von dieser Vorspannung der Druckfeder 36 bestimmten Druckschwellwert, so bewegt sich der Kolben 46 bzw. der mit ihm gekoppelte Schaltteller 38 in Richtung des Grundkörpers 14, bis sich die erste Axialkraft und die zweite Axialkraft wieder im Gleichgewicht befinden, bzw. bis der Schaltteller 38 an seinem gehäuseseitigen Endanschlag anliegt. Dabei folgt der federbelastete Betätigungsstößel 70 der Bewegung des Schalttellers 38 und löst gegebenenfalls im Schaltelement 62 einen Schaltvorgang aus, der die beschriebene Änderung der Spannungsverhältnisse an dessen Kontakten 68 bewirkt. Die geänderten Spannungsverhältnisse können von einer externen und mit dem Druckschalter 10 durch Signalleitungen verbundenen Steuerung erfaßt bzw. ausgewertet werden.

Die beschriebene mechanische Betätigung des Schaltelements 62 erlaubt es, dieses als funktionsfähige vormontierbare Baueinheit herzustellen, in einem einfachen Steckarbeitsgang in den Innenraum eines Gerätesteckers 60 einzubauen und elektrisch zu kontaktieren. Dieser Gerätestecker 60 kann als Baugruppe danach von außen, d.h. vom Betreiber zugänglich, an den Druckschalter 10 angebaut werden. Dieser Aufbau erlaubt es, die Vorteile eines berührungslos arbeitenden Schaltelements 62 mit denen einer mechanischen Betätigung desselben zu kombinieren, ohne daß zusätzlicher Montage- oder Einstellaufwand entsteht. Konstruktive Anpassungen der hydraulischen Komponenten des Druckschalters 10 an die Wirkungsweise des Schaltelements 62 sind nicht erforderlich - eine Optimierung dieser Bauteile bzgl. ihrer hydraulischen Funktion ist somit möglich.

Selbstverständlich sind Änderungen oder Ergänzungen am beschriebenen Ausführungsbeispiel möglich, ohne vom Grundgedanken der Erfindung abzuweichen. Diesbezüglich anzumerken ist, daß der beschriebene Druckschalter 10 sowohl für pneumatische als auch für hydraulische Anwendungen geeignet ist. Ebenso ist es möglich diesen Druckschalter 10 über eine Veränderung der Vorspannung der Druckfeder 36 auf verschiedene Druckschaltschwellen einzustellen. Vorzugsweise ist neben dem Gehäuse des Gerätesteckers 60 auch der Betätigungsstößel 70 spritzgußtechnisch aus Kunststoff herzustellen, wobei aus Verschleißgründen ein glasfasergefülltes Kunststoffmaterial verwendet werden kann.

## Patentansprüche

1. Druckschalter zur Steuerung druckmittelbetätigter Anlagen mit einer in einem Druckschaltergehäuse (16) befindlichen Druckkammer (50), in die ein durch den Druck im Druckmittel verschiebbarer Kolben (46) hineinragt, und mit einem mit dem Kolben (46) in Wirkverbindung stehenden Schaltelement (62), das beim Überschreiten einer Druckschwelle im Druckmittel ein veränderliches Spannungssignal abgibt und das einen berührungslos arbeitenden magnetfeldempfindlichen Sensor und eine Auswerteelektronik aufweist,
**dadurch gekennzeichnet, dass**
das Schaltelement (62) als ein mittels eines Betätigungsstößels 70 mechanisch betätigbares Einzelbauelement ausgebildet ist,
dass das Schaltelement (62) in das Gehäuse (64) eines von außen am Druckschaltergehäuse (16) befestigbaren Gerätesteckers (60) eingebaut ist,
dass der Gerätestecker nach außen führende Kontakte (68) aufweist,
dass das Schaltelement (62) über Steckkontakte mit inneren Enden der Kontakte (68) des Gerätesteckers (60) elektrisch leitend verbunden ist, und
dass die Bewegung des Kolbens (46) zur Messung durch den Sensor mechanisch auf den Betätigungsstößels (70) übertragen wird.

2. Druckschalter nach einem der Anspruch 1, **dadurch gekennzeichnet, dass** das Gehäuse des Gerätesteckers (60) wenigstens abschnittsweise in eine Aufnahmeöffnung (58) des Druckschalters (10) hineinragt und zur Zentrierung bzw. drehfesten Fixierung einen Formschluss mit der Aufnahmeöffnung (58) ausbildet.

3. Druckschalter nach einem der Ansprüche 1 oder 2, **dadurch gekennzeichnet, dass** der Stößel (70) aus verschleißfestem Kunststoff, insbesondere aus einem glasfaserverstärkten Polyamid gefertigt ist.

4. Druckschalter nach einem der Ansprüche 1 bis 3, **dadurch gekennzeichnet, dass** der Kolben (46) des Druckschalters entgegen der Kraft einer Feder (36) verschiebbar angeordnet ist und dass die Vorspannung dieser Feder (36) zur Einstellung der Druckschwelle veränderbar ist.

5. Druckschalter nach einem der Ansprüche 1 bis 4, **dadurch gekennzeichnet, dass** der Kolben (46) mit einem auf das Schaltelement (62) einwirkenden Betätigungselement (38) versehen ist, dass das Betätigungselement (38) scheibenförmig ausgebildet ist und von der der Bewegung des Kolbens (46) entgegenwirkenden Feder (36) beaufschlagt ist.

6. Druckschalter nach einem der Ansprüche 1 bis 5, **dadurch gekennzeichnet, dass** der Kolben (46) ein rotationssymmetrisches Bauelement mit zwei identisch ausgebildeten Enden ist.

7. Druckschalter nach einem der Ansprüche 1 bis 6, **dadurch gekennzeichnet, dass** das Gehäuse des Gerätesteckers (60) aus Kunststoff in einem Spritzgiessverfahren hergestellt und die Kontakte (68) wenigstens teilweise eingespritzt sind.

8. Druckschalter nach einem der Ansprüche 1 bis 7, **dadurch gekennzeichnet, dass** der magnetfeldempfindliche Sensor des Schaltelements (62) ein Hall-Sensor ist.

## Claims

1. A pressure switch for controlling systems operated by pressure medium having, located in a pressure switch housing (16), a pressure chamber (50) into which extends a piston (46) that can be displaced by the pressure in the pressure medium, and having a switching element (62) which is connected interactively with the piston (46) and emits a variable voltage signal when a pressure threshold in the pressure medium is exceeded and which has a noncontacting magnetic-field-sensitive sensor and evaluation electronics,
**characterized by the fact that**
the switching element (62) is formed as an individual structural element which can be operated mechanically by means of an actuating stem (70), that the switching element (62) is installed in the housing (64) of a device connector (60) which can be fastened from the outside to the pressure switch housing (16),
that the device connector has contacts (68) leading to the outside, that the switching element (62) is connected in an electrically conductive manner via plug-in contacts to the inner ends of the contacts (68) of the device connector (60), and
that the movement of the piston (46) is mechanically transmitted to the actuating stem (70) for measurement by the sensor.

2. A pressure switch according to claim 1, **characterized by** the fact that the housing of the device connector (60) extends at least partially into a receiving opening (58) of the pressure switch (10) and connects in a contour-locking manner with the receiving opening (58) for the purpose of centring or anti-rotational fixing.

3. A pressure switch according to either of claims 1 or 2, **characterized by** the fact that the stem (70) is fabricated from wear-resistant plastic, in particular from a glass fibre reinforced polyamide.

4. A pressure switch according to any of claims 1 to 3, **characterized by the** fact that the piston (46) of the pressure switch is arranged so as to be displaceable against the force of a spring (36) and that the pretension of this spring (36) can be varied to adjust the pressure threshold.

5. A pressure switch according to any of claims 1 to 4, **characterized by the fact that** the piston (46) is provided with an actuating element (38) acting upon the switching element (62), that the actuating element (38) is formed in the shape of a disk against which bears the spring (36) acting in a direction counter to the movement of the piston (46).

6. A pressure switch according to any of claims 1 to 5, **characterized by the fact that** the piston (46) is a rotationally symmetrical structural element with two identically formed ends.

7. A pressure switch according to any of claims 1 to 6, **characterized by the fact that** the housing of the device connector (60) is manufactured by injection moulding and that the contacts (68) are at least partially injected.

8. A pressure switch according to any of claims 1 to 7, **characterized by the** fact that the magnetic-field-sensitive sensor of the switching element (62) is a Hall sensor.

## Revendications

1. Un manocontact pour la commande d'installations à actionnement par fluide de pression, doté d'une chambre (50) de pression, qui est située dans un corps (16) de manocontact et où pénètre un piston (46) pouvant coulisser sous l'effet de la pression du fluide de pression, et doté d'un élément (62) de commutation, qui est relié en termes d'action au piston (46), qui lors du dépassement d'un seuil de pression donné du fluide de pression émet un signal de tension pouvant varier et qui présente un capteur sensible aux champs magnétiques, travaillant sans contact, et une électronique d'évaluation,
**caractérisé en ce que**
l'élément (62) de commutation est conçu sous forme d'élément constructif individuel, pouvant être actionné par voie mécanique à l'aide d'un coulisseau (70) d'actionnement,
que l'élément (62) de commutation est intégré dans le corps (64) d'un connecteur (60) d'appareil pouvant être fixé de l'extérieur sur le corps (16) de manocontact,
que le connecteur d'appareil présente des contacts (68) menant vers l'extérieur,
que des fiches relient l'élément (62) de commutation aux extrémités intérieures des contacts (68) du connecteur (60) d'appareil, cette liaison étant électriquement conductrice, et
que le mouvement du piston (46) est transmis par voie mécanique au coulisseau (70) d'actionnement, pour être mesuré par le capteur.

2. Un manocontact selon la revendication n° 1, **caractérisé en ce que** le corps du connecteur (60) d'appareil pénètre, au moins de façon partielle, dans une ouverture (58) de positionnement du manocontact (10) et ferme de façon géométrique avec l'ouverture (58) de positionnement pour le centrage ou, le cas échéant, pour une fixation ne permettant aucune rotation.

3. Un manocontact selon une des revendications n° 1 ou n° 2, **caractérisé en ce que** le coulisseau (70) est fabriqué en matière plastique très résistante à l'usure, en particulier en polyamide armé de fibres de verre.

4. Un manocontact selon une des revendications n° 1 à n° 3, **caractérisé en ce que** le piston (46) du manocontact est disposé de façon à pouvoir coulisser contre la force exercée par un ressort (36) et que la précontrainte de ce ressort (36) est modifiable pour calibrer le seuil de pression.

5. Un manocontact selon une des revendications n° 1 à n° 4, **caractérisé en ce que** le piston (46) est pourvu d'un élément (38) d'actionnement agissant sur l'élément (62) de commutation, que l'élément (38) d'actionnement est conçu en forme de disque et est sollicité par le ressort (36) contrecarrant le mouvement du piston (46).

6. Un manocontact selon une des revendications n° 1 à n° 5, **caractérisé en ce que** le piston (46) est un élément constructif à symétrie de révolution, doté de deux extrémités de conception identique.

7. Un manocontact selon une des revendications n° 1 à n° 6, **caractérisé en ce que** le corps du connecteur (60) d'appareil est fabriqué en matière plastique dans un procédé de moulage par injection et les contacts (68) sont au moins partiellement injectés.

8. Un manocontact selon une des revendications n° 1 à n° 7, **caractérisé en ce que** le capteur sensible aux champs magnétiques de l'élément (62) de commutation est un capteur de Hall.
